# EUROPEAN PATENT APPLICATION

(11) **EP 4 492 431 A1**
(43) Date of publication of application: **15.01.2025**
(21) Application number: 24186272.1
(22) Date of filing: 03.07.2024
(51) Int. Cl.: H01L 21/02, C23C 16/00

(54) **METHOD OF PROCESSING SUBSTRATE, METHOD OF MANUFACTURING SEMICONDUCTOR DEVICE, PROGRAM AND SUBSTRATE PROCESSING APPARATUS**

(30) Priority: 04.07.2023 JP 2023110344
(71) Applicant: Kokusai Electric Corporation, Tokyo 101-0045 (JP)
(72) Inventor: KOIDE, Hiroyuki, Toyama-shi, Toyama 939-2393 (JP); SUYAMA, Nagisa, Toyama-shi, Toyama 939-2393 (JP); NAGAHASHI, Tomoya, Toyama-shi, Toyama 939-2393 (JP)
(74) Representative: Bardehle Pagenberg Partnerschaft mbB Patentanwälte Rechtsanwälte

(57) **Abstract**

There is provided a technique that includes: (a) supplying a decomposable process gas containing silicon to the substrate to form a layer containing a Si-Si-Si bond on the substrate; and (b) supplying a reaction gas to the substrate to dissociate the Si-Si-Si bond.

## Description

### CROSS-REFERENCE TO RELATED APPLICATION

This application is based upon and claims the benefit of priority from Japanese Patent Application No. 2023-110344, filed on July 4, 2023, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

In the related art, a process of manufacturing a semiconductor device includes forming an insulating film such as a silicon oxide (SiO₂) film or a silicon nitride (Si₃N₄) film on a substrate.

### SUMMARY

According to some embodiments of the present disclosure, there is provided a technique that is capable of improving charge trap characteristics by controlling an amount of a Si-Si-Si bond (Si substitution amount) and an amount of a Si-Si bond in a film formed on a substrate.

According to some embodiments of the present disclosure, there is provided a technique that includes: (a) supplying a decomposable process gas containing silicon to the substrate to form a layer containing a Si-Si-Si bond on the substrate; and (b) supplying a reaction gas to the substrate to dissociate the Si-Si-Si bond.

### BRIEF DESCRIPTION OF DRAWINGS

The accompanying drawings, which are incorporated in and constitute a part of the specification, illustrate embodiments of the present disclosure.
FIG. 1 is a schematic configuration view illustrating a substrate processing apparatus used in a method of processing a substrate according to some embodiments of the present disclosure.
FIG. 2 is a cross-sectional view taken along line A-A of FIG. 1, illustrating the substrate processing apparatus used in a method of processing a substrate according to some embodiments of the present disclosure.
FIG. 3 is a block diagram illustrating a controller provided in the substrate processing apparatus used in a method of processing a substrate according to some embodiments of the present disclosure.
FIG. 4 is a diagram illustrating a flow of a method of processing a substrate (a semiconductor manufacturing method) according to some embodiments of the present disclosure.
FIG. 5 is a schematic diagram illustrating a structure of Si substitution and N defect according to the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to unnecessarily obscure aspects of the various embodiments.

Hereinafter, the present disclosure will be described in detail.

The present disclosure is not limited to the following embodiments. The following embodiments may be appropriately modified within the scope of the purpose of the present disclosure.

In the present disclosure, a numerical range represented by using "to" indicates a range that includes numerical values written before and after "to" as minimum and maximum values, respectively.

In numerical ranges described incrementally in the present disclosure, an upper limit or a lower limit described in a certain numerical range may be replaced with an upper limit or a lower limit of another incremental numerical range.

Further, in numerical ranges described in the present disclosure, an upper limit or a lower limit described in a certain numerical range may be replaced with values illustrated in the examples.

In the present disclosure, the term "step" includes independent steps and steps that cannot be clearly distinguished from other steps when a predetermined purpose is achieved.

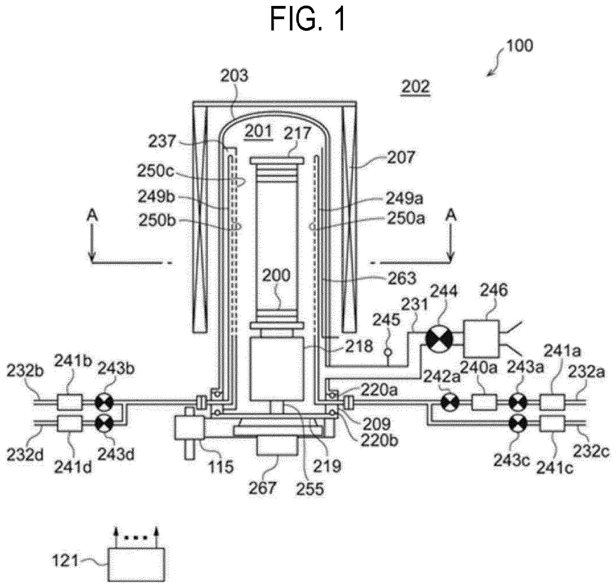

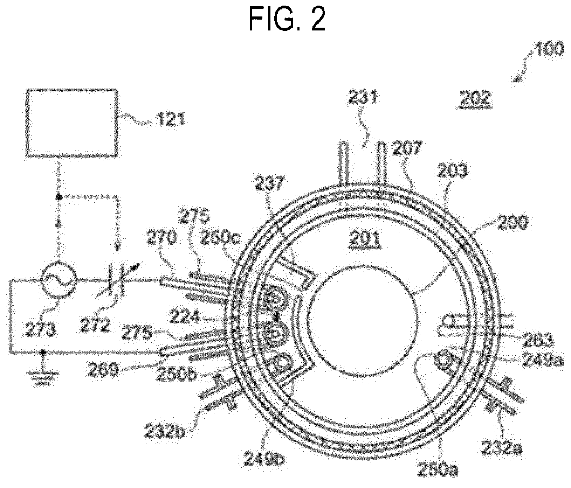

Hereinafter, some embodiments of the present disclosure will be described mainly with reference to FIGS. 1 and 2. In addition, drawings used in the following description are schematic, and dimensional relationships, ratios, and the like of the respective components in the drawings may not match actual ones. Further, among the multiple drawings, dimensional relationships, ratios, and the like of the respective components may not match one another.

### <Substrate Processing Apparatus>

As illustrated in FIG. 1, a substrate processing apparatus 100 includes a process furnace 202. A heater 207 is arranged as a temperature regulator at the process furnace 202. The heater 207 is formed in a cylindrical shape and is supported by a holding plate so as to be vertically installed. The heater 207 also functions as an activator (exciter) configured to activate (excite) a gas thermally.

A reaction tube 203, which constitutes a reaction container (process container), is disposed inside the heater 207 to be concentric with the heater 207. The reaction tube 203 is made of, for example, a heat-resistant material such as quartz (SiO₂) or silicon carbide (SiC), and is formed in a cylinder shape with its upper end closed and lower end opened.

A manifold 209 is disposed to be concentric with the reaction tube 203 under the reaction tube 203. The manifold 209 is made of, for example, a metal such as stainless steel (SUS), and is formed in a cylinder shape with both of its upper and lower ends opened.

The upper end of the manifold 209 engages with the lower end of the reaction tube 203 to support the reaction tube 203.

An O-ring 220a is provided as a seal between the manifold 209 and the reaction tube 203. The manifold 209 is supported by a heater base, such that the reaction tube 203 is vertically installed. A process container (reaction container) mainly includes the reaction tube 203 and the manifold 209. A process chamber 201 is formed in a hollow cylindrical area of the process container. The process chamber 201 is configured to be capable of accommodating a plurality of wafers 200 serving as substrates. The wafers 200 are processed in the process chamber 201.

Nozzles 249a and 249b that extend vertically are provided in the process chamber 201 to penetrate a sidewall of the manifold 209. Gas supply pipes 232a and 232b are respectively connected to the nozzles 249a and 249b. As such, the reaction tube 203 is provided with two nozzles 249a and 249b and two gas supply pipes 232a and 232b, thereby being configured to be capable of supplying a plurality of types (two types in this case) of gases into the process chamber 201.

The gas supply pipe 232a is provided with a mass flow controller (MFC) 241a serving as a flow rate controller (flow rate control part), a valve 243a serving as an on-off valve, a reservoir (gas trap) 240a configured to be capable of temporarily storing a gas, and a valve 242a, which are arranged in this order from the upstream side of gas flow. Further, an inert gas supply pipe 232c is connected to the gas supply pipe 232a at the downstream side of the valve 243a. The inert gas supply pipe 232c is provided with a mass flow controller 241c serving as a flow rate controller (flow rate control part) and a valve 243c serving as an on-off valve, which are arranged in this order from the upstream side of gas flow.

The nozzle 249a described above is connected to a tip end of the gas supply pipe 232a. The nozzle 249a is installed in an arc-shaped space between an inner wall of the reaction tube 203 and the wafers 200 so as to extend upward from a lower side to an upper side of the inner wall of the reaction tube 203 along an arrangement direction of the wafers 200. The nozzle 249a is formed as an L-shaped long nozzle. A gas supply hole 250a configured to supply a gas is formed at a side surface of the nozzle 249a. The gas supply hole 250a is open toward the center of the reaction tube 203. A plurality of gas supply holes 250a are formed from a lower side to an upper side of the reaction tube 203. Each of the gas supply holes 250a is formed with the same opening area and the gas supply holes 250a are arranged at the same opening pitch.

The reservoir 240a is, for example, constituted by a gas tank or a spiral pipe with a larger gas capacity than a normal pipe. By opening or closing the valve 243a on the upstream side of the reservoir 240a and the valve 242a on the downstream side of the reservoir 240a, it is possible to charge a gas supplied from the gas supply pipe 232a into the reservoir 240a or supply the gas charged in the reservoir 240a into the process chamber 201. By closing the valve 242a and opening the valve 243a, a gas with the flow rate adjusted by the MFC 241a may be charged into the reservoir 240a. When a predetermined amount of gas is charged into the reservoir 240a and an internal pressure of the reservoir 240a reaches a predetermined pressure, it is possible to supply (flash supply) a high-pressure gas charged in the reservoir 240a into the process chamber 201 via the gas supply pipe 232a and the nozzle 249a instantly (within a short time) by closing the valve 243a and opening the valve 242a. In addition, the valve 243a may remain open during the flash supply.

Further, when a process gas is supplied into the process chamber 201, the process gas may be supplied directly into the process chamber 201 without being charged in the reservoir 240a (non-flash supply).

The supply pipe 232b is provided with a mass flow controller (MFC) 241b serving as a flow rate controller (flow rate control part) and a valve 243b serving as an on-off valve, which are arranged in this order from the upstream side of gas flow. Further, an inert gas supply pipe 232d is connected to the gas supply pipe 232b at the downstream side of the valve 243b. The inert gas supply pipe 232d is provided with a MFC 241d and a valve 243d, which are arranged in this order from the upstream side of gas flow.

The nozzle 249b is connected to a tip end of the gas supply pipe 232b. The nozzle 249b is installed in a buffer chamber 237 serving as a gas dispersion space.

As illustrated in FIG. 2, the buffer chamber 237 is installed in an arc-shaped space between the inner wall of the reaction tube 203 and the wafers 200 from the lower side to the upper side of the inner wall of the reaction tube 203 along the arrangement direction of the wafers 200. A gas supply hole 250c configured to supply a gas is formed at an end of a wall of the buffer chamber 237 adjacent to the wafers 200. The gas supply hole 250c is open toward the center of the reaction tube 203. A plurality of gas supply holes 250c are formed from the lower side to the upper side of the reaction tube 203. Each of the gas supply holes 250c is formed with the same opening area and the gas supply holes 250c are arranged at the same opening pitch.

The nozzle 249b is installed at an end opposite to the end of the buffer chamber 237 where the gas supply holes 250c are formed, so as to extend upward along the arrangement direction of the wafers 200 from the lower side to the upper side of the inner wall of the reaction tube 203. The nozzle 249b is formed as an L-shaped long nozzle. A gas supply hole 250b configured to supply a gas is formed in a side surface of the nozzle 249b. The gas supply hole 250b is open toward the center of the buffer chamber 237. Similar to the gas supply holes 250c of the buffer chamber 237, a plurality of gas supply holes 250b are formed from the lower side to the upper side of the reaction tube 203.

Each of the plurality of gas supply holes 250b may be formed with the same opening area and the gas supply holes 250b may be arranged at the same opening pitch from an upstream side (lower side) to a downstream side (upper side) in a case where a pressure difference between an interior of the buffer chamber 237 and an interior of the process chamber 201 is small. In a case where the pressure difference is large, the opening area may be increased or the opening pitch may be decreased from the upstream side to the downstream side.

By adjusting the opening areas or opening pitches of the respective gas supply holes 250b of the nozzle 249b from the upstream side to the downstream side as described above, first, a gas is ejected from the respective gas supply holes 250b at approximately the same flow rate, although there is a difference in flow velocity. Then, the gas ejected from the respective gas supply holes 250b is introduced into the buffer chamber 237 to enable the difference in the flow velocity of the gas to be equalized within the buffer chamber 237.

The gas ejected from the respective gas supply holes 250b of the nozzle 249b into the buffer chamber 237 undergoes alleviation of particle velocity of each gas within the buffer chamber 237, and thereafter, is ejected from the gas supply holes 250c of the buffer chamber 237 into the process chamber 201. Thus, the gas ejected from the respective gas supply holes 250b of the nozzle 249b into the buffer chamber 237 becomes a gas with a uniform flow rate and flow velocity when ejected from the respective gas supply holes 250c of the buffer chamber 237 into the process chamber 201.

As described above, in the embodiments of the present disclosure, the gas is transferred via the nozzles 249a and 249b and the buffer chamber 237, which are arranged in a vertically long annular space, i.e., a cylindrical space, defined by the inner wall of the reaction tube 203 and the edges of the plurality of wafers 200 placed.

Then, the gas is first ejected into the process chamber 201 in the vicinity of the wafers 200 from the gas supply holes 250a to 250c, which are opened respectively in the nozzles 249a and 249b and the buffer chamber 237. Further, a main flow of gas within the process chamber 201 is directed parallel to surfaces of the wafers 200, i.e., horizontally. A reacted residual gas after flowing on the surfaces of the wafers 200 flows toward an exhaust pipe 231 to be described below. However, a flow direction of the residual gas is appropriately specified depending on a position of an exhaust port.

A process gas, e.g., a gas containing silicon (Si) (silicon-containing gas) is supplied from the gas supply pipe 232a into the process chamber 201 via the MFC 241a, the valve 243a, the reservoir 240a, the valve 242a, and the nozzle 249a.

A reaction gas, e.g., a gas containing nitrogen (N) (nitrogen-containing gas) is supplied from the gas supply pipe 232b into the process chamber 201 via the MFC 241b, the valve 243b, and the nozzle 249b. In addition, the reaction gas is a substance with a molecular structure (chemical structure) different from that of the process gas.

An inert gas is supplied from the gas supply pipes 232c and 232d into the process chamber 201 via the MFCs 241c and 241d, the valves 243c and 243d, the gas supply pipes 232a and 232b, and the nozzles 249a and 249b, respectively. The inert gas acts as a purge gas, a carrier gas, a dilution gas, etc.

The gas supply pipe 232a, the MFC 241a, the valve 243a, the reservoir 240a, and the valve 242a constitute a process gas supply system.

The gas supply pipe 232b, the MFC 241b, and the valve 243b constitute a reaction gas supply system.

The gas supply pipes 232c and 232d, the MFCs 241c and 241d, and the valves 243c and 243d constitute an inert gas supply system.

As illustrated in FIG. 2, two elongated rod-shaped electrodes 269 and 270 are arranged in the buffer chamber 237 along a stacking direction of the wafers 200 from the lower side to the upper side of the reaction tube 203. Each of the rod-shaped electrodes 269 and 270 is provided parallel to the nozzle 249b. The rod-shaped electrodes 269 and 270 are protected respectively by being covered by electrode protective tubes 275 from an upper side to a lower side. One of the rod-shaped electrodes 269 and 270 is connected to a radio frequency power supply 273 via a matcher 272, while the other is connected to a ground, which is a reference potential. By applying radio frequency (RF) power between the rod-shaped electrodes 269 and 270 from the radio frequency power supply 273 via the matcher 272, a plasma is generated in a plasma generation area 224 between the rod-shaped electrodes 269 and 270. The rod-shaped electrodes 269 and 270 and the electrode protective tubes 275 mainly constitute a plasma source serving as a plasma generator (plasma generation part). The matcher 272 and the radio frequency power supply 273 may also be considered as being included in the plasma source. The plasma source functions as an activator (exciter) configured to activate (excite) a gas into a plasma state as described below. In addition, in a case where the gas is not activated into a plasma state, the plasma generator may not be provided.

The electrode protective tubes 275 are structured to allow the respective rod-shaped electrodes 269 and 270 to be inserted into the buffer chamber 237 while being isolated from an atmosphere in the buffer chamber 237. In a case where a concentration of oxygen in the electrode protective tubes 275 is similar to that of an outside air (atmosphere), the rod-shaped electrodes 269 and 270 respectively inserted into the electrode protective tubes 275 may be oxidized due to heat from the heater 207. By charging an inert gas such as nitrogen (N₂) gas to the interior of the electrode protective tubes 275 or purging the interior of the electrode protective tubes 275 with an inert gas such as nitrogen (N₂) gas by using an inert gas purger, it is possible to reduce the concentration of oxygen in the interior of the electrode protective tubes 275, which may prevent the oxidation of the rod-shaped electrodes 269 and 270.

The exhaust pipe 231 is connected to the reaction tube 203 to exhaust the atmosphere in the process chamber 201. One end of the exhaust pipe 231 is connected to an exhaust port at the lower end of the process chamber 201. Further, a vacuum pump 246, serving as an exhauster, is connected to the exhaust pipe 231 via a pressure sensor 245, serving as a pressure detector (pressure detecting part) configured to detect the internal pressure of the process chamber 201, and an auto pressure controller (APC) valve 244 serving as an exhaust value (pressure regulator). The APC valve 244 is configured to be capable of performing or stopping the exhaust of the process chamber 201 by being opened or closed while the vacuum pump 246 is in operation, and to be capable of regulating the internal pressure of the process chamber 201 by adjusting an opening state of the valve based on pressure information detected by the pressure sensor 245 while the vacuum pump 246 is in operation. The exhaust pipe 231, the APC valve 244, and the pressure sensor 245 mainly constitute an exhaust system. In addition, the vacuum pump 246 may also be considered as being included in the exhaust system. The exhaust pipe 231 is not limited to being provided at the reaction tube 203, but may be provided at the manifold 209, similar to the nozzles 249a and 294b.

A seal cap 219, which serves as a furnace opening lid configured to be capable of airtightly sealing a lower end opening of the manifold 209, is provided under the manifold 209.

The seal cap 219 is configured to make contact with a lower end of the manifold 209 from a vertical lower side. An O-ring 220b, which serves as a seal making contact with the lower end of the manifold 209, is provided at an upper surface of the seal cap 219. A rotary shaft 255 of a rotator 267 passes through the seal cap 219 and is connected to a boat 217 to be described below. The rotator 267 is configured to rotate the wafers 200 by rotating the boat 217. The seal cap 219 is configured to be vertically raised or lowered by a boat elevator 115, which serves as an elevator installed vertically outside the reaction tube 203. The boat elevator 115 is configured to load or unload the boat 217 into or out of the process chamber 201 by raising or lowering the seal cap 219. The boat elevator 115 is configured as a transporter (transport equipment) configured to transport the boat 217 and the wafers 200 supported by the boat 217 into or out of the process chamber 201.

The boat 217 serving as a substrate holder is configured to support a plurality of wafers 200, e.g., 25 to 200 wafers, in such a state that the wafers 200 are arranged in a horizontal posture and in multiple stages along a vertical direction with the centers of the wafers 200 aligned with one another. The boat 217 is made of, for example, a heat-resistant material such as quartz or SiC. An insulator 218, which is made of, for example, a heat-resistant material such as quartz or SiC, is provided at the lower side of the boat 217, making it difficult for heat from the heater 207 to be transferred to the seal cap 219.

A temperature sensor 263 serving as a temperature detector is installed inside the process chamber 201. Based on temperature information detected by the temperature sensor 263, a state of supplying electric power to the heater 207 is regulated such that a temperature distribution in the process chamber 201 becomes a desired temperature distribution. Similar to the nozzles 249a and 249b, the temperature sensor 263 is formed in an L-shape, and is provided along the inner wall of the reaction tube 203.

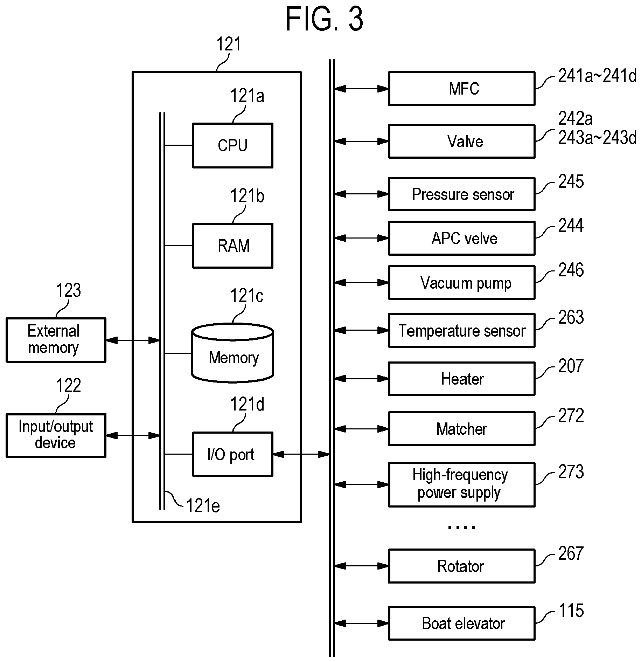

As illustrated in FIG. 3, a controller 121 serving as a control part (control means or unit) is constituted as a computer including a central processing unit (CPU) 121a, random access memory (RAM) 121b, memory 121c, and I/O port 121d. The RAM 121b, memory 121c, and I/O port 121d are configured to enable data exchange with the CPU 121a via an internal bus 121e. An input/output device 122, which is constituted as, e.g., a touch panel, is connected to the controller 121.

The memory 121c is constituted by, for example, a flash memory and a hard disk drive (HDD). The memory 121c readably stores a control program that controls an operation of a substrate processing apparatus or a process recipe in which a substrate processing procedure or condition of a film formation and the like, which are described below, is written. The RAM 121b is constituted as a memory area (work area) where programs, data, etc. read by the CPU 121a are temporarily held.

The I/O port 121d is connected to, e.g., the above-described MFCs 241a to 241d, valves 242a, 243a to 243d, reservoir 240a, pressure sensor 245, APC valve 244, vacuum pump 246, temperature sensor 263, heater 207, rotator 267, boat elevator 115, matcher 272, radio frequency power supply 273, and the like.

The CPU 121a is configured to read and execute the control programs from the memory 121c and read the process recipes from the memory 121c, in response to an input of operation commands from the input/output device 122, and the like. The CPU 121a is configured to control flow rate regulating operations of various gases by the MFCs 241a to 241d, opening/closing operations of the valves 242a, 243a to 243d, an operation of storing the process gas by the reservoir 240a, a pressure regulating operation by the APC valve 244 based on an opening/closing operation of the APC valve 244 and the pressure sensor 245, actuating and stopping operations of the vacuum pump 246, a temperature regulating operation of the heater 207 based on the temperature sensor 263, operations of rotating and adjusting a rotational speed of the boat 217 by the rotator 267, an elevating operation of the boat 217 by the boat elevator 115, an impedance regulating operation by the matcher 272, and supply of power from the radio frequency power supply 273, and the like, according to contents of the read process recipes. Herein, the process recipe is combined to cause the controller 121 to execute each procedure in a substrate processing step such as a film-forming step described below to obtain predetermined results, and functions as programs.

The controller 121 may be constituted as a general-purpose computer without being limited to being constituted as a dedicated computer. For example, the controller 121 of the embodiments of the present disclosure may be constituted by providing an external memory (e.g., semiconductor memory such as a USB memory or a memory card) 123 storing the aforementioned programs and installing the programs to a general-purpose computer by using the external memory 123. However, a configuration of supplying the programs to the computer is not limited to supplying the programs via the external memory 123. For example, the programs may be supplied by using a communication facility such as the Internet or a dedicated line without using the external memory 123. The memory 121c or the external memory 123 is constituted as a computer-readable recording medium. Hereinafter, these are collectively referred to simply as "recording medium." The term "recording medium" used in the present disclosure may refer to the memory 121c, the external memory 123, or both. In addition, the programs may be provided to the computer by using a communication facility such as the Internet or a dedicated line without using the external memory 123.

### <Substrate Processing Step>

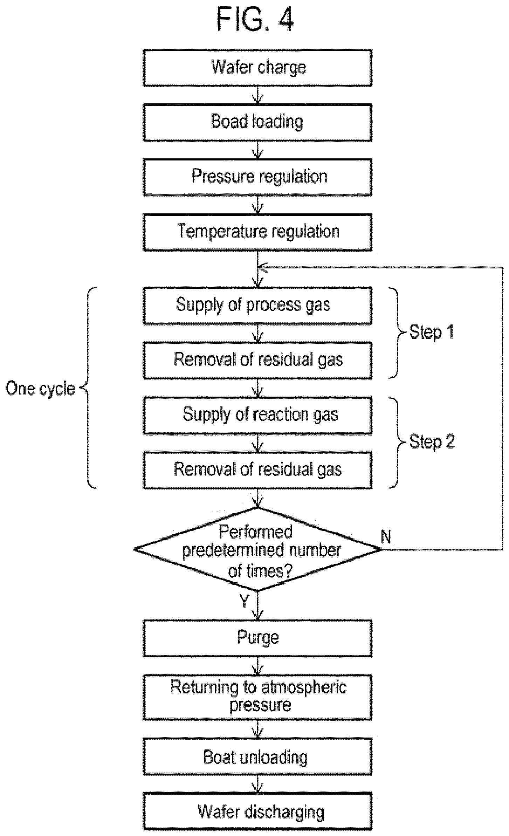

As a process of manufacturing a semiconductor device (i.e., a method of processing a substrate according to the present disclosure), an example of a step of forming a thin film on the wafer 200 will be described with reference to FIG. 4. In the following description, an operations of the respective components constituting a substrate processing apparatus are controlled by the controller 121.

In a method of processing a substrate (a method of manufacturing a semiconductor device) of the present disclosure, a layer containing a Si-Si bond and -Si- is formed on a wafer 200 by performing: (a) supplying a decomposable process gas containing silicon to the wafer 200 to form a layer containing a Si-Si-Si bond on the wafer 200; and (b) supplying a reaction gas to the wafer 200 to dissociate the Si-Si-Si bond.

An improvement in charge trap characteristics of the layer formed on the wafer 200 by the method of processing the substrate (the method of manufacturing the semiconductor device) is presumably because an amount of the Si-Si bond (N defect) contained in the layer may be easily controlled.

That is, in Step (a), the layer containing the Si-Si-Si bond (Si substitution), serving as a source of N defect generation, is formed.

Then, in Step (b), the amount of the Si-Si bond (N defect) may be controlled by supplying the reaction gas to regulate the dissociation of the Si-Si-Si bond.

When the term "wafer" is used in the present disclosure, it may refer to "a wafer itself," or "a stack of a wafer and a predetermined layer or film, etc. formed on a surface of the wafer." When the term "a surface of a wafer" is used in the present disclosure, it may refer to "a surface of a wafer itself," or "a surface of a predetermined layer or film, etc. formed on a wafer." When the term "substrate" is used in the present disclosure, it is synonymous with the term "wafer."

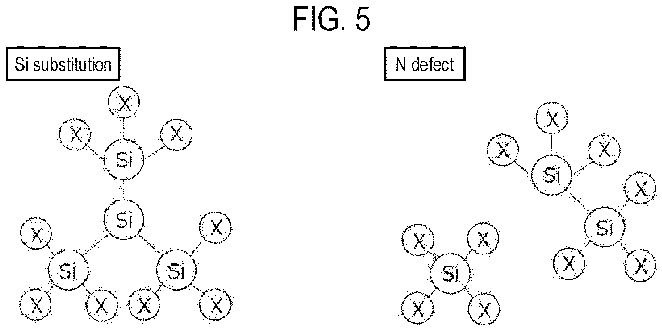

In the present disclosure, the "Si-Si-Si bond" refers to three or more silicon atoms being directly bonded to one silicon atom, as illustrated in FIG. 5.

In FIG. 5, "X" independently represents one selected from the group of hydrogen atoms, alkyl groups, amines, halogen atoms, and dangling bonds (unbonded).

Further, in the present disclosure, the "Si-Si-Si bond" may also be indicated as a "Si substitution (Si dB defect)."

In the present disclosure, the "Si-Si bond" refers to one silicon atom being directly bonded to another silicon atom, as illustrated in FIG. 5.

In FIG. 5, "X" is the same as described above.

Further, in the present disclosure, the "Si-Si bond" may also be referred to as a "N defect (Si-H defect)."

In the present disclosure, "-Si-" indicates that no silicon atom is directly bonded to one silicon atom. Further, X is bonded to -Si-, as illustrated in FIG. 5.

In the present disclosure, a "processing temperature" refers to a temperature of the wafer 200 or an internal temperature of the process chamber 201, and a "processing pressure" refers to an internal pressure of the process chamber 201. Further, a "processing time" refers to a duration of the processing.

### (Wafer Charging and Boat Loading)

When the plurality of wafers 200 are charged to the boat 217 (wafer charging), the boat 217 is lifted by the boat elevator 115 and is loaded into the process chamber 201 (boat loading). At this time, the seal cap 219 airtightly closes (seals) the lower end of the reaction tube 203 via the O-ring 220b.

### (Pressure Regulation and Temperature Regulation)

The interior of the process chamber 201, i.e., a space where the wafers 200 exist, is vacuum-exhausted (decompression-exhausted) by the vacuum pump 246 to reach a desired pressure (state of vacuum). At this time, the internal pressure of the process chamber 201 is measured by the pressure sensor 245, and the APC valve 244 is feedback-controlled based on the measured pressure information (pressure regulation). The vacuum pump 246 is maintained in a constant operating state at least until the wafers 200 are completely processed.

Further, the wafers 200 in the process chamber 201 are heated by the heater 207 to reach a desired temperature. At this time, a state of supplying electric power to the heater 207 is feedback-controlled based on the temperature information detected by the temperature sensor 263 such that the process chamber 201 reaches a predetermined temperature (temperature regulation). The heating of the inside of the process chamber 201 by the heater 207 continues at least until the wafers 200 are completely processed.

### (Film-Forming Process)

In a film-forming process, the following Step 1 and Step 2 are sequentially performed.

### [Step 1]

This step may include (a) supplying a decomposable process gas (hereinafter, referred to as a "process gas") containing silicon to the wafer 200 to form a layer containing a Si-Si-Si bond, and may further include removing (exhausting) a residual gas in the process chamber 201.

Specifically, the valve 243a is opened to cause the process gas to flow through the gas supply pipe 232a. The process gas, which is controlled in flow rate by the MFC 241a and is stored in the reservoir 240a, is flash-supplied into the process chamber 201 from the gas supply holes 250a of the nozzle 249a, and is exhausted from the exhaust pipe 231. In addition, in this step, the process gas may be supplied directly into the process chamber 201 without being stored in the reservoir 240a (non-flash supply). At this time, the valve 243c is opened simultaneously to cause an inert gas such as nitrogen (N₂) gas to flow through the gas supply pipe 232c. The inert gas flowing through the gas supply pipe 232c is regulated in flow rate by the MFC 241c. The inert gas with the regulated flow rate is supplied into the process chamber 201 together with the process gas and is exhausted from the exhaust pipe 231.

A processing condition of this step when the gas containing Si of the present disclosure is used as the process gas is exemplified as follows:
Processing temperature: 500 to 1000 degrees C, specifically 600 to 800 degrees C, more specifically 650 to 750 degrees C;
Processing pressure: 1 to 2666 Pa, specifically 10 to 1333 Pa;
Supply flow rate of process gas: 1 to 2000 sccm, specifically 10 to 1000 sccm; and
Supply time of process gas: 1 to 120 seconds, specifically 1 to 60 seconds.

In addition, notation of a numerical ranges such as "500 to 1000 degrees C" in the present disclosure refers that a lower limit and an upper limit are included in that range. Thus, for example, "500 to 1000 degrees C" means "500 degrees C or higher and 1000 degrees C or lower." This applies similarly to other numerical ranges. Further, the processing temperature in the present disclosure refers to the temperature of the wafer 200 or the internal temperature of the process chamber 201, and the processing pressure refers to the internal pressure of the process chamber 201. Further, in a case where 0 sccm is included in the supply flow rate, 0 sccm means a case of not supplying that gas. This applies similarly to the following description.

Step (a) may be performed under a condition where decomposition of the process gas is suppressed. Thus, it is possible to reduce a Si substitution amount and enhance charge trap characteristics.

For example, the condition where decomposition of the process gas is suppressed may include: (1) a condition where the temperature of the wafer 200 is equal to or lower than a temperature at which the process gas is decomposed (specifically, lower than the temperature at which the process gas is decomposed); (2) a condition where a flow velocity of the process gas is faster than a flow velocity of a reaction gas which is described below; and (3) a condition where a pass time of the process gas through the process chamber 201 (a space where the wafer 200 exists or a space on the wafer 200) is shorter than a decomposition time of the process gas.

In the present disclosure, "decomposition of a process gas is suppressed" refers to suppression of dissociation (cut-off) of the Si-Si-Si bond.

For the above (1), for example, when the gas containing Si of the present disclosure is used as the process gas (decomposition temperature: it varies depending on the gas used, but, for example, 300 degrees C), specifically, the temperature of the wafer 200 may be set to be lower than the decomposition temperature of the process gas. This ensures good uniformity of a film formed on the wafer 200.

For the above (2), for example, when the flow velocity of the process gas is set to 0.5 to 30 m/s, the flow velocity of the reaction gas may be set to, specifically, 0.1 to 3.0 m/s, and more specifically, 0.5 to 1.5 m/s.

The supply of the reaction gas may be performed by the above-described flash supply. Thus, it is possible to reduce a time for which the reaction gas exists in the process chamber 201, thereby enabling suppression of the decomposition of the process gas due to heat or the like.

By suppressing the decomposition of the process gas, it is possible to reduce the Si substitution amount. In addition, the temperature of the wafer 200 may not be set lower than the decomposition temperature of the process gas during processing at such a flow velocity, and the process may be performed at a temperature equal to or higher than the decomposition temperature. The temperature of the wafer 200 higher than the decomposition temperature may be, for example, within a range of 500 to 800 degrees C, specifically within a range of 600 to 800 degrees C, and more specifically within a range of 650 to 750 degrees C. By setting such temperature ranges, it is possible to improve a reactivity of the reaction gas while suppressing the decomposition of the process gas, thereby improving characteristics of a film formed on the wafer 200. In addition, the temperature equal to or higher than the decomposition temperature includes a temperature equal to the decomposition temperature or a temperature higher than the decomposition temperature.

For the above (3), for example, when the gas containing Si of the present disclosure is used as the process gas, the pass time of the gas through the process chamber 201 may be within a range of 0.01 to 0.5 seconds, and specifically within a range of 0.05 to 0.1 seconds. Thus, it is possible to suppress the decomposition of the process gas, thereby reducing the Si substitution amount.

Further, in the present disclosure, Step (a) may be performed under a condition where the process gas is decomposed. Thus, it is possible to increase the Si substitution amount and increase the N defect amount caused by the supply of the reaction gas.

The condition where the process gas is decomposed may include, for example, a condition where a pressure applied to the process gas is higher than a pressure applied to the reaction gas.

Specifically, when the pressure applied to the reaction gas is within a range of 1 to 1333 Pa, the pressure applied to the process gas may be within a range of 10 to 2666 Pa.

After the layer containing the Si-Si-Si bond is formed on the wafer 200, the valve 243a is closed to stop the supply of the process gas. Then, the interior of the process chamber 201 is vacuum-exhausted to remove any unreacted gas remaining in the process chamber 201 or the process gas after contributing to formation of the layer containing the Si-Si-Si bond from the interior of the process chamber 201. At this time, the valve 243e remains open to maintain the supply of the inert gas into the process chamber 201. This enhances an effect of removing (purging) the unreacted gas remaining in the process chamber 201 or the process gas after contributing to the formation of the layer containing the Si-Si-Si bond from the interior of the process chamber 201.

A processing condition of this step when a N₂ gas is used as the inert gas is exemplified as follows:
Supply flow rate of inert gas: 100 to 1000 sccm, specifically 300 to 500 sccm; and
Supply time of inert gas: 1 to 60 seconds, specifically 2 to 20 seconds.
Other processing conditions are to be the same as the processing conditions during the supply of the process gas in this step.

Examples of the decomposable process gas containing silicon of the present disclosure may include both inorganic and organic process gases.

Examples of inorganic process gases may include silicon-based gases containing halogens such as dichlorosilane (H₂SiCl₂) gas, hexachlorodisilane (Si₂Cl₆, abbreviation: HCDS) gas, and tetrachlorosilane (SiCl₄) gas, and silicon-based gases not containing halogens such as SiH₄, Si₂H₆, and Si₃H₈.

Examples of organic process gases may include aminosilane-based gases such as tetrakisdimethylaminosilane (Si(N(CH₃)₂)₄) gas, trisdimethylaminosilane (Si(N(CH₃)₂)₃H) gas, bisdiethylaminosilane (Si(N(C₂H₅)₂)₂H₂) gas, and bis(tert-butylamino)silane (SiH₂(NH(C₄H₉))₂) gas.

These process gases may be used alone or in combination of two or more.

Among those, inorganic process gases such as HCDS gas, Si₂H₆ gas, Si₂I₆ gas, and Si₂Br₆ gas, which contain the Si-Si bond, and organic process gases such as SiH₂(NH(C₄H₉))₂ gas, which contain the Si-Si bond, are may be used from the viewpoint of ease of forming the layer containing the Si-Si-Si bond.

By supplying the gas containing Si of the present disclosure to the wafer 200 under the condition of the present disclosure, it is possible to form the layer containing the Si-Si-Si bond on the wafer 200.

A mechanism of forming the layer containing the Si-Si-Si bond may be presumed as follows.

First, a Si-Si bond of a gas molecule containing the Si-Si bond supplied into the process chamber 201 is cut off. The cut-off of the Si-Si bond results in generation of SiRx ("X" is an integer of 1 or more, and SiRx indicates a gas smaller in molecular size than the process gas). The generated SiRx is bonded to another SiRx to generate the Si-Si-Si bond. It is presumed that the Si-Si-Si bond is adsorbed on the wafer 200 physically and/or chemically, forming the layer containing the Si-Si-Si bond. In addition, in this case, "R" indicates a ligand contained in a Si precursor of the present disclosure. Examples of the ligand include hydrogen (H), chlorine (Cl), an amino group, an alkylamino group, etc. For example, when the process gas is HCDS, "R" is Cl, "X" is an integer from 1 to 3, and SiRx is SiClx.

Examples of the inert gas may include rare gases such as nitrogen (N₂) gas, argon (Ar) gas, helium (He) gas, neon (Ne) gas, and xenon (Xe) gas. The inert gas may be used alone or in combination of two or more. This applies similarly to each step which is described below.

### [Step 2]

After Step 1, this step includes (b) supplying a reaction gas to the wafer 200 to dissociate the Si-Si-Si bond of the layer containing the Si-Si-Si bond formed on the wafer 200. Further, this step may include removing (exhausting) a residual gas in the process chamber 201.

Thus, it is possible to form a layer containing -Si- and the Si-Si bond obtained by dissociating the Si-Si-Si bond.

Specifically, the valve 243b is opened to cause the reaction gas to flow through the gas supply pipe 232b. A flow rate of the reaction gas is regulated by the MFC 241b. The reaction gas with the regulated flow rate is supplied from the nozzle 249b into the buffer chamber 237. At this time, the reaction gas supplied into the buffer chamber 237 is plasma-excited by applying a radio frequency power between the first rod-shaped electrode 269 and the second rod-shaped electrode 270 from the radio frequency power supply 273 via the matcher 272. The plasma-excited reaction gas is supplied as active species into the process chamber 201 from the gas supply holes 250c and is exhausted from the gas exhaust pipe 231. At this time, the valve 243d is simultaneously opened to cause an inert gas to flow through the inert gas supply pipe 232d. The inert gas is supplied into the process chamber 201 together with the reaction gas and is exhausted from the exhaust pipe 231.

A processing condition of this step is exemplified as follows:
Processing temperature: 500 to 1000 degrees C, specifically 600 to 800 degrees C, more specifically 650 to 750 degrees C;
Processing pressure: 1 to 4000 Pa, specifically 10 to 10000 Pa;
Supply flow rate of reaction gas: 10 to 10000 sccm, specifically 100 to 5000 sccm;
Supply time of reaction gas: 1 to 120 seconds, specifically 10 to 60 seconds; and
Radio frequency power applied between rod-shaped electrodes: 0 to 1000 W.

Further, when supplying the reaction gas, it is possible to thermally activate the reaction gas in a non-plasma manner by appropriately regulating the APC valve 244, without plasma excitation, to set the internal pressure of the process chamber 201 to be a pressure within a range of, for example, 50 to 3000 Pa. Further, by thermally activating and supplying the reaction gas, it is possible to cause a soft reaction, thus softly performing a nitridation described below. Further, in a case where the reaction gas is not plasma-excited, a configuration of generating a plasma in the substrate processing apparatus may not be provided.

Thereafter, the valve 243b of the supply pipe 232b is closed to stop the supply of the reaction gas. At this time, the APC valve 244 of the exhaust pipe 231 remains open, and the interior of the process chamber 201 is vacuum-exhausted by the vacuum pump 246 to remove the reaction gas remaining in the process chamber 201 from the interior of the process chamber 201. Further, at this time, the valve 243d remains open to maintain the supply of the inert gas into the process chamber 201. This enhances an effect of removing (purging) the reaction gas remaining in the process chamber 201 from the interior of the process chamber 201.

A processing condition of this step when using a N₂ gas as the inert gas is exemplified as follows:
Supply flow rate of inert gas: 100 to 1000 sccm, specifically 300 to 500 sccm; and
Supply time of inert gas: 1 to 60 seconds, specifically 2 to 20 seconds.

Examples of the reaction gas of the present disclosure may include gases containing nitrogen element (N) and hydrogen element (H). Further, instead of gases containing N and H, gases containing N and deuterium (D) may be used. Examples of these gases may include nitrogen hydrogen-based gases such as N₂ gas + H₂ gas, ammonia (NH₃) gas, diazen (N₂H₂) gas, hydrazine (N₂H₄) gas, N₃H₈ gas, and ND₃ gas. These reaction gases may be used alone or in combination of two or more.

In addition, in the present disclosure, notation of two gases together such as "N₂ gas + H₂ gas" indicates a mixed gas of H₂ gas and N₂ gas. When supplying a mixed gas, two gases may be mixed (pre-mixed) in a supply pipe, and then supplied into the process chamber 201. Alternatively, two gases may be separately supplied from different supply pipes into the process chamber 201, and then mixed (post-mixed) in the process chamber 201.

Among the aforementioned gases, from the viewpoint of increasing the N defect amount, nitrogen hydrogen-based gases such as N₂ gas + H₂ gas, NH₃ gas, N₂H₂ gas, N₂H₄ gas, N₃H₈ gas, and ND₃ gas may be used.

By supplying the reaction gas of the present disclosure to the wafer 200, the layer containing the Si-Si bond and -Si- is formed. Further, Si in the Si-Si bond and -Si- of the layer partially react with the reaction gas and are nitrided, leading to formation of a silicon nitride layer (SiN layer).

A mechanism by which the layer containing the Si-Si bond and -Si- is formed may be presumed as follows.

The nitrogen atom from the reaction gas enters the Si-Si-Si bond of the layer containing the Si-Si-Si bond formed in Step (a). As a result, it is presumed that the Si-Si-Si bond is dissociated into the Si-Si bond and -Si-, leading to modification into the layer containing the Si-Si bond and -Si-.

Si in the Si-Si bond obtained by the dissociation by the reaction gas may be bonded to the nitrogen atom.

-Si- may be bonded to the nitrogen atom and another ligand.

The nitrogen atom may be used as the element to which Si in the Si-Si bond and -Si- are bonded to. Thus, it is possible to at least partially modify the layer containing the Si-Si bond and -Si- formed on the wafer 200, thereby forming a SiN layer. Further, this may also increase the N defect amount, enhancing charge trap characteristics.

The above-described another ligand is independently at least one selected from the group of hydrogen atom, alkyl group, amine, halogen atom, and dangling bond (unbonded). The another ligand may include an element contained in a molecule of a precursor gas, a ligand contained in a molecule of a precursor gas, or dangling bonds that are not bonded to the element and the ligand.

### (Predetermined Number of Repetitions)

A cycle including the above-described Steps 1 and 2 may be performed a predetermined number of times (n times, where n is an integer equal to or greater than 1). The above-described cycle may be performed a plurality of times from the viewpoint of enabling an easy regulation of a refractive index, a thickness, and/or a composition of the layer formed on the surface of the wafer 200.

When performing the cycle including Steps 1 and 2 a predetermined number of times, supply conditions of the process gas and the reaction gas may be set based on the refractive index (RI) of the layer and the amount of the Si-Si-Si bond in the layer.

Further, when performing the cycle including Steps 1 and 2 a predetermined number of times, supply conditions of the process gas and the reaction gas may be set based on the RI of the layer, the amount of the Si-Si-Si bond in the layer, and the amount of the Si-Si bond (N defect amount) in the layer. Thus, it is possible to easily control the charge trap characteristics.

When setting supply conditions of the process gas and the reaction gas, the RI of the layer formed on the surface of the wafer 200 may be specifically within a range of 2.0 to 2.10. More specifically, the RI of the layer may be within a range of 2.02 to 2.07. Desired semiconductor device characteristics may be met by setting the RI of the layer to be within the range of 2.0 to 2.10.

In a case where the RI of the layer is less than 2.0, the N defect amount may be decreased, deteriorating the charge trap characteristics. In a case where the RI of the layer is greater than 2.10, the Si substitution amount is increased, which may increase a leakage current. As a result, the desired semiconductor device characteristics may not be met.

The RI of the layer may be measured by using an equipment such as spectroscopic ellipsometry, for example.

Further, either or both of a supply condition of the process gas and a supply condition of the reaction gas may be set based on a relationship between the Si substitution amount and the N defect amount in the layer formed on the surface of the wafer 200. In this case, the relationship between the Si substitution amount and the N defect amount is represented by a graph where a horizontal axis is the Si substitution amount and a vertical axis is the N defect amount. Specifically, the Si substitution amount may be 1E+18 or less, and the N defect amount may be 2.5E+18 or more. By setting the Si substitution amount and the N defect amount to such ranges, the desired semiconductor device characteristics may be met. More specifically, the supply condition may be set such that the Si substitution amount is 5E+17 or less and the N defect amount is 3.0E+18 or more. More specifically, the supply condition may be set such that the Si substitution amount is 1E+17 or less and the N defect amount is 3.5E+18 or more. In a case where the Si substitution amount is greater than 1E+18, the leakage current may increase. As a result, the desired semiconductor device characteristics may not be met. In a case where the N defect amount is less than 2.5E+18, charge trap characteristics may deteriorate. As a result, the desired semiconductor device characteristics may not be met. Further, as the Si substitution amount become smaller, the leakage current may be decreased. However, the Si substitution amount may be regulated to be within the above-described range of RI. Further, as the N defect amount becomes larger, the charge trap amount may be increased. However, the N defect amount may be regulated to be within the above-described range of RI.

The Si substitution amount and the N defect amount may be calculated from an amount of dangling bonds contained in the layer, for example, by using an electron spin resonance (ESR) method.

### (Purge and Returning to Atmospheric Pressure)

After film formation on the wafer 200 is completed, an inert gas is supplied into the process chamber 201 and is exhausted from the exhaust pipe 231. The inert gas acts as a purge gas. Thus, the interior of the process chamber 201 is purged with the inter gas, and a gas, reaction by-products, and the like remaining in the process chamber 201 are removed from the inside of the process chamber 201 (purge). Thereafter, the internal atmosphere of the process chamber 201 is substituted with the inert gas (inert gas substitution) and the internal pressure of the process chamber 201 is returned to the normal pressure (returning to atmospheric pressure).

### (Boat Unloading and Wafer Discharging)

The seal cap 219 is lowered by the boat elevator 115 to open the lower end of the reaction tube 203. Then, the processed wafers 200 supported by the boat 217 are unloaded from the lower end of the manifold 209 to the outside of the reaction tube 203 (boat unloading). The processed wafers 200 are unloaded from the reaction tube 203 and are then discharged from the boat 217 (wafer discharging).

### <Other Embodiments>

The embodiments of the present disclosure are specifically described above. However, the present disclosure is not limited to the above-described embodiments and may be changed in various ways without departing from the gist thereof.

For example, a series of processes may be performed continuously (in-situ) in the same process chamber (process container) 201 as described above. Further, at least one process among the above-described processes may be performed (ex-situ) in different process chambers (process containers). In either case, effects similar to those described in the above embodiments are obtained. In addition, when the above-described processes are performed in-situ, it is possible to suppress, e.g., contamination of the wafer 200 or changes in the surface state of the wafer 200, which may occur when unloading the wafer 200 out of the process chamber or when loading the wafer 200 from the outside of the process chamber between the processes. Further, performing these processes in-situ allows for a reduction in transition time between the processes. On the other hand, in a case where these processes are performed ex-situ, it is possible to perform each process concurrently in different process chambers, thereby increasing productivity.

In the above-described embodiments, an example of forming a film by using a batch-type substrate processing apparatus capable of processing multiple substrates at once are described. The present disclosure is not limited to the above-described embodiments, and for example, may be suitably applied even when forming a film by using a single-wafer-type substrate processing apparatus configured to process one or several substrates at once. Further, in the above-described embodiments, an example of forming a film by using a substrate processing apparatus equipped with a hot-wall-type process furnace are described. The present disclosure is not limited to the above-described embodiments, and may also be suitably applied when forming a film by using a substrate processing apparatus equipped with a cold-wall-type process furnace.

Even when using such a substrate processing apparatus, it is possible to perform each process under the same process procedures and process conditions as in the above-described embodiments and modifications, and to achieve the same effects as in the above-described embodiments and modifications.

According to the present disclosure in some embodiments, it is possible to improve charge trap characteristics by controlling an amount of a Si-Si-Si bond (Si substitution amount) and an amount of a Si-Si bond in a film formed on a substrate.

While certain embodiments are described above, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate comprising:
(a) supplying a decomposable process gas containing silicon to the substrate to form a layer containing a Si-Si-Si bond on the substrate; and
(b) supplying a reaction gas to the substrate to dissociate the Si-Si-Si bond.

2. The method of claim 1, wherein the process gas is a process gas containing a Si-Si bond.

3. The method of claim 1 or 2, wherein in (b), the Si-Si-Si bond is dissociated into a Si-Si bond and -Si-, and a layer containing the Si-Si bond and the -Si- is formed.

4. The method of claim 1 or 3, wherein the reaction gas is a gas containing a nitrogen element and a hydrogen element.

5. The method of claim 3, wherein the reaction gas is a gas containing a nitrogen element, and
wherein in (b), Si in the Si-Si bond of the layer containing the Si-Si bond and the -Si- is bonded to the nitrogen element, and the -Si- is bonded to the nitrogen element and another ligand.

6. The method of any one of claims 1 to 5, wherein (a) is performed under a condition:
where decomposition of the process gas is prevented;
where a temperature of the substrate is equal to or lower than a decomposition temperature of the process gas;
where a flow velocity of the process gas is faster than a flow velocity of the reaction gas;
where a pass time of the process gas through a space where the substrate exists is shorter than a decomposition time of the process gas;
where the process gas decomposes; or
where a pressure in a space where the substrate exists is higher than a pressure in a space where the substrate exists when performing (b).

7. The method of any one of claims 1 to 6, further comprising (c) performing (a) and (b) a predetermined number of times to form a layer containing Si on the substrate.

8. The method of claim 7, wherein supply conditions of the process gas and the reaction gas are set based on a refractive index of the layer and an amount of the Si-Si bond in the layer.

9. The method of claim 7 or 8, wherein supply conditions of the process gas and the reaction gas are set based on a refractive index of the layer, an amount of the Si-Si-Si bond in the layer, and an amount of the Si-Si bond in the layer.

10. The method of claim 9, wherein the supply conditions of the process gas and the reaction gas are set such that the amount of the Si-Si-Si bond in the layer is equal to or less than 1E+18 and the amount of the Si-Si bond in the layer is equal to or greater than 2.5E+18.

11. The method of claim 8, wherein the supply conditions of the process gas and the reaction gas are set such that the refractive index of the layer is within a range of 2.0 to 2.10.

12. The method of claim 8, wherein the supply conditions of the process gas and the reaction gas are set such that the refractive index of the layer is within a range of 2.02 to 2.07.

13. A method of manufacturing a semiconductor device comprising the method of claim 1.

14. A program that causes, by a computer, a substrate processing apparatus to perform a process comprising:
(a) supplying a decomposable process gas containing silicon to a substrate to form a layer containing a Si-Si-Si bond on the substrate; and
(b) supplying a reaction gas to the substrate to dissociate the Si-Si-Si bond.

15. A substrate processing apparatus comprising:
a process gas supply system configured to supply a decomposable process gas containing silicon to a substrate;
a reaction gas supply system configured to supply a reaction gas to the substrate; and
a controller configured to be capable of controlling the process gas supply system and the reaction gas supply system so as to perform a process comprising:
(a) supplying the process gas to the substrate to form a layer containing a Si-Si-Si bond on the substrate; and
(b) supplying the reaction gas to the substrate to dissociate the Si-Si-Si bond.
